# EUROPÄISCHE PATENTANMELDUNG

(11) **EP 0 684 618 A2**
(43) Veröffentlichungstag der Anmeldung: **29.11.1995**
(21) Anmeldenummer: 95107042.4
(22) Anmeldetag: 10.05.1995
(51) Int. Cl.: H01G 4/00, H01L 21/334

(54) **Verfahren zur Herstellung eines Siliziumkondensators**

(30) Priorität: 26.05.1994 DE 4418430
(71) Anmelder: SIEMENS AKTIENGESELLSCHAFT, D-80333 München (DE)
(72) Erfinder: Wendt, Hermann, Dr., D-85630 Grasbrunn (DE); Willer, Josef, Dr., D-85521 Riemerling (DE); Reisinger, Hans, Dr., D-82031 Grünwald (DE); Lehmann, Volker, Dr., D-80689 München (DE)

(57) **Zusammenfassung**

Zur Herstellung eines Siliziumkondensators werden in einem n-dotierten Siliziumsubstrat (1) Lochöffnungen (2) erzeugt, an deren Oberfläche ein p⁺⁻ dotiertes Gebiet (3) gebildet wird und deren Oberfläche mit einer dielektrischen Schicht mit einer leitfähigen Schicht versehen wird. Das Siliziumsubstrat (1) wird von der Rückseite her gedünnt mittels einer Ätzung, die Silizium selektiv zu p-dotiertem Silizium angreift und die daher bei Erreichen des p⁺⁻dotierten Gebietes (3) stoppt.

## Beschreibung

Aus der europäischen Patentanmeldung EP 05 28 281 ist ein Siliziumkondensator bekannt. Dieser umfaßt ein n-dotiertes Siliziumsubstrat, dessen Oberfläche durch eine elektrochemische Ätzung in einem fluoridhaltigen, sauren Elektrolyten, in dem das Substrat als Anode verschaltet ist, auf charakteristische Weise strukturiert ist. Bei der elektrochemischen Ätzung bilden sich an der Oberfläche des Substrats mehr oder weniger regelmäßig angeordnete Lochstrukturen. Die Lochstrukturen weisen Aspektverhältnisse bis in den Bereich 1 : 1000 auf. Die Oberfläche der Lochstrukturen ist mit einer dielektrischen Schicht und einer leitfähigen Schicht versehen. Leitfähige Schicht, dielektrische Schicht und Siliziumsubstrat bilden einen Kondensator, in dem, durch die durch die Lochstrukturen bewirkte Oberflächenvergrößerung, spezifische Kapazitäten bis zu 100 u.FV/mm³ erzielt werden. Um die Leitfähigkeit des Substrats zu erhöhen, wird vorgeschlagen, dieses höher n zu dotieren.

Der Erfindung liegt die Aufgabe zugrunde, ein weiteres Verfahren zur Herstellung eines Siliziumkondensators anzugeben, das bezüglich des Einbaus des Siliziumkondensators in ein Gehäuse optimiert ist.

Diese Aufgabe wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren wird nach der Bildung von Lochöffnungen in einem n-dotierten Substrat durch elektrochemisches Ätzen entlang der Oberfläche der Lochöffnungen ein p⁺⁻ dotiertes Gebiet erzeugt. Nach Aufbringen einer dielektrischen Schicht und einer elektrisch leitfähigen Schicht auf die Oberfläche der Lochöffnungen wird dann das Siliziumsubstrat von einer zweiten, der ersten gegenüberliegenden Hauptfläche her gedünnt. Dabei wird eine Ätzung eingesetzt, die Silizium selektiv zu p⁺⁻dotiertem Silizium angreift. Diese Ätzung stoppt daher, sobald die Oberfläche des p⁺⁻dotierten Gebietes freigelegt ist.

Zum Einbau eines Siliziumkondensators in ein üblicherweise verwendetes Gehäuse, insbesondere ein SMD-Gehäuse ist bei Verwendung eines Siliziumsubstrats mit einer üblichen Dicke von 500 um eine Dünnung des Siliziumsubstrats auf 200 um erforderlich. Die nach der Dünnung erzielte Dicke des verbleibenden Siliziumsubstrats wird in dem erfindungsgemäßen Verfahren über die Tiefe der Lochöffnungen und die Dotiertiefe des p⁺⁻dotierten Gebietes eingestellt. Da die Ätzung auf dem p⁺⁻ dotierten Gebiet stoppt, kann in dem erfindungsgemäßen Verfahren das n-dotierte Silizium des zu entfernenden Teils des Substrates vollständig entfernt werden, ohne daß ein Freiätzen der Lochöffnungen befürchtet werden muß.

Üblicherweise werden Siliziumsubstrate mit Halbleiterbauelementen vor dem Einbau der Halbleiterbauelemente in ein Gehäuse von der Rückseite her dünn geschliffen. Die verbleibende Dicke des Substrats wird durch den Schleifprozeß bestimmt. Die beim Dünnschleifen abgetragene Materialdicke ist bei üblicherweise eingesetzten Schleifprozessen nur auf etwa 20 um genau. Damit wäre beim Siliziumkondensator die Gefahr des Freilegens der Lochöffnungen und damit des Ausfalls des Bauelementes gegeben. Zu geringes Dünnschleifen dagegen würde es nicht erlauben, mit der Rückseitenmetallisierung das hoch p-dotierte Gebiet direkt anzuschließen.

Ein weiterer Vorteil des erfindungsgemäßen Verfahrens liegt darin, daß die Oberfläche des p⁺⁻ dotierten Gebietes freigelegt wird. Darauf kann unmittelbar ein niederohmiger Kontakt aufgebracht werden, ohne daß eine weitere Dotierung des Siliziums zur Reduzierung des Serienwiderstandes erforderlich wäre.

Um die Zeit für die Ätzung zur Dünnung des Siliziumsubstrats in vertretbaren Grenzen zu halten, liegt es im Rahmen der Erfindung, zunächst von der zweiten Hauptfläche her das Siliziumsubstrat um eine vorgegebene Dicke zu dünnen. Dann wird die zu p⁺⁻dotiertem Silizium selektive Ätzung durchgeführt, mit der die endgültige Dicke des Siliziumkondensators bestimmt wird. Die vorgegebene Dicke, die durch Dünnschleifen entfernt wird, wird dabei so eingestellt, daß der Schleifprozeß in sicherer Entfernung von dem p⁺⁻dotierten Gebiet beendet wird.

Das p⁺⁻dotierte Gebiet wird vorzugsweise durch Gasphasendiffusion mit Diboran (B₂H₆) hergestellt, wobei eine Dotierstoffkonzentration im p⁺⁻ dotierten Gebiet von größer oder gleich 10¹⁹ cm-³ eingestellt wird. Mit diesem Verfahren kann nach einer Diffusionszeit von ca. 5 Stunden bei 1050°C eine Dotierstofftiefe von 1 um erzielt werden.

Die zu p⁺⁻dotiertem Silizium selektive Ätzung zur Dünnung des Siliziumsubstrates wird vorzugsweise mit KOH mit (10 ± 2) Gewichtsprozent und bei (60 ± 2) _{°}C durchgeführt. Ferner kann die selektive Ätzung mit KOH mit anderen Konzentrationen und Temperaturen, mit NaOH mit verschiedenen Konzentrationen und Temperaturen, mit Ethylendiamin mit verschiedenen Konzentrationen und Temperaturen zum Beispiel 70 Gewichtsprozent und 80°C sowie mit anderen basischen Ätzen erfolgen.

Im folgenden wird die Erfindung anhand eines Ausführungsbeispiels und der Figuren näher erläutert.
Figur 1 zeigt ein Siliziumsubstrat mit Lochöffnungen.
Figur 2 zeigt das Siliziumsubstrat nach Bildung eines p⁺⁻dotierten Gebietes an der Oberfläche der Lochöffnungen.
Figur 3 zeigt das Siliziumsubstrat nach Abscheidung einer dielektrischen Schicht und einer leitfähigen Schicht und Bildung eines Kontaktes zur leitfähigen Schicht.
Figur 4 zeigt das gedünnte Siliziumsubstrat nach einer zu p⁺⁻dotiertem Silizium selektiven Ätzung.

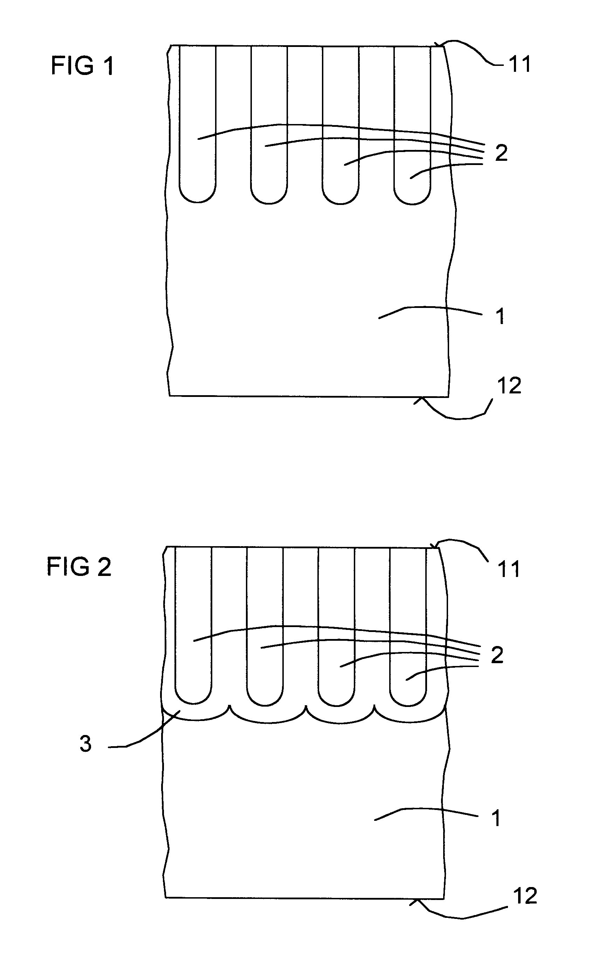

Ein Siliziumsubstrat 1 aus n-dotiertem, einkristallinem Silizium, das einen spezifischen Widerstand von 5 Ohm . cm aufweist, wird durch elektrochemisches Ätzen an einer ersten Hauptfläche 11 mit einer Vielzahl von Lochöffnungen 2 versehen (siehe Figur 1).

Dazu wird die erste Hauptfläche 11 mit einem Elektrolyten in Kontakt gebracht. Als Elektrolyt wird zum Beispiel eine 6-gewichtsprozentige Flußsäure (HF) verwendet. Das Siliziumsubstrat 1 wird als Anode mit einem Potential von 3 Volt beaufschlagt. Das Siliziumsubstrat 1 wird von einer zweiten, der ersten gegenüberliegenden Hauptfläche 12 her beleuchtet. Dabei wird eine Stromdichte von 10 mA/cm² eingestellt. Bei der elektrochemischen Ätzung bewegen sich Minoritätsladungsträger in dem n-dotierten Silizium zu der mit dem Elektrolyten in Kontakt stehenden ersten Hauptfläche 11. An der ersten Hauptfläche 11 bildet sich eine Raumladungszone aus. Da die Feldstärke im Bereich von Vertiefungen in der ersten Hauptfläche 11 größer ist als außerhalb davon, bewegen sich die Minoritätsladungsträger bevorzugt zu diesen Punkten. Dadurch kommt es zu einer Strukturierung der ersten Hauptfläche 11. Je tiefer eine anfänglich kleine Unebenheit durch die Ätzung wird, desto mehr Minoritätsladungsträger bewegen sich dorthin und desto stärker ist der Ätzangriff an dieser Stelle.

Die Lochöffnungen 2 beginnen von Unebenheiten in der ersten Hauptfläche 11 aus zu wachsen, die mit statistischer Verteilung in jeder Oberfläche vorhanden sind. Um eine gleichmäßige Verteilung der Lochöffnungen 2 zu erzielen, ist es vorteilhaft, die erste Hauptfläche 11 vor der elektrochemischen Ätzung gezielt mit Unebenheiten zu versehen, die als Keim für den Ätzangriff bei der nachfolgenden elektrochemischen Ätzung wirken. Diese Unebenheiten können zum Beispiel mit Hilfe konventioneller Photolithographie hergestellt werden.

Nach ungefähr 180 Minuten Ätzzeit weisen die Lochöffnungen 2 einen Durchmesser von 2 um bei einer Tiefe von 175 um auf.

Anschließend wird das Siliziumsubstrat 1 gründlich mit Wasser gespült.

Anschließend wird zum Beispiel durch Gasphasendiffusion von Bor ein p⁺⁻dotiertes Gebiet 3 entlang der Oberfläche der Lochöffnungen 2 erzeugt (siehe Figur 2). Das p⁺⁻dotierte Gebiet 3 weist eine Dotierstoffkonzentration im Bereich von 10¹⁹ bis 10²¹ cm³ auf. Das p⁺⁻dotierte Gebiet 3 wird mit einer Dotiertiefe von ca. 1 um hergestellt. Bei der Bildung des p⁺⁻dotierten Gebietes 3 beträgt die Diffusionszeit 5 Stunden bei einer Ofentemperatur von 1050°C.

Nachfolgend wird auf die Oberfläche der Lochöffnungen 2 eine dielektrische Schicht 4 aufgebracht. Die dielektrische Schicht 4 wird zum Beispiel durch kombiniertes Aufbringen von Si0₂, Si₃N₄ und nochmals Si0₂ hergestellt und weist eine Dicke von zum Beispiel 60 nm auf. Alternativ wird die dielektrische Schicht 4 durch anodische Oxidation oder thermische Oxidation gebildet. Die Bildung der dielektrischen Schicht 4 durch kombiniertes Aufbringen von Si0₂, Si₃N₄ und Si0₂ ist jedoch in Bezug auf eine für den Siliziumkondensator erforderliche geringe Defektdichte der dielektrischen Schicht 4 vorzuziehen.

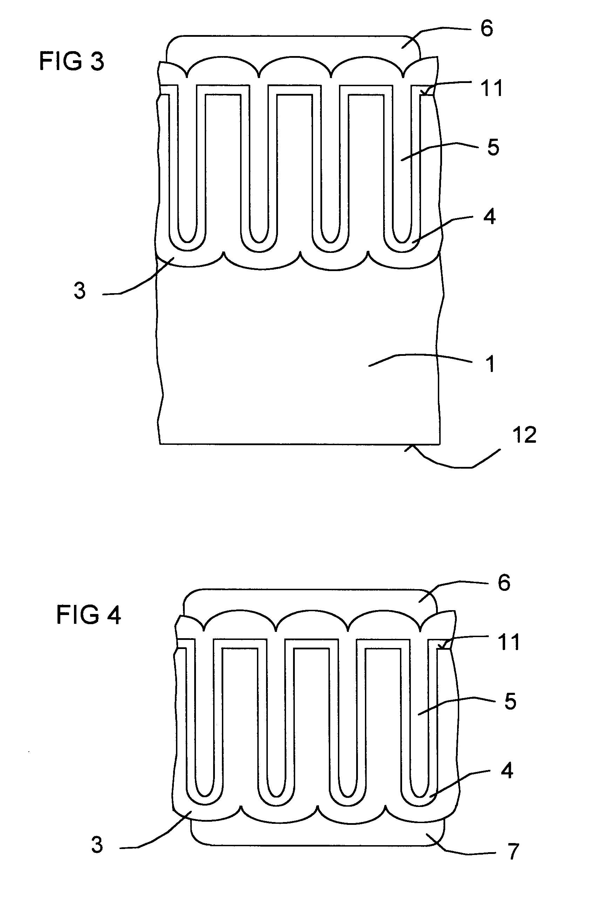

Auf die Oberfläche der dielektrischen Schicht 4 wird eine elektrisch leitfähige Schicht 5 aus zum Beispiel n-dotiertem Polysilizium aufgebracht. Die leitfähige Schicht 5 kann dabei den verbliebenen Freiraum in den Lochöffnungen 2 vollständig auffüllen. Auf der Oberfläche der leitfähigen Schicht 5 wird ein erster Kontakt 6 aus zum Beispiel Aluminium abgeschieden (siehe Figur 3).

Anschließend wird das Substrat 1 von der zweiten Hauptfläche 12 her zunächst durch Dünnschleifen auf eine Dicke von ca. 200 um gedünnt. Der verbliebene Rest von n-dotiertem Silizium des Siliziumsubstrats 1 wird in einer zu p⁺⁻dotiertem Silizium selektiven Ätzung mit zum Beispiel 10 Gewichtsprozent KOH bei 60°C entfernt. Diese Ätzung greift undotiertes und n-dotiertes Silizium an, während sie p⁺⁻dotiertes Silizium nicht angreift. Das heißt, der Ätzprozeß stoppt, sobald eine Oberfläche von p-dotiertem Silizium mit einer Dotierstoffkonzentration von größer gleich 10¹⁹ cm-³ erreicht ist. In dem erfindungsgemäßen Verfahren stoppt die Ätzung daher, sobald von der zweiten Hauptfläche 12 her die Oberfläche des p⁺⁻dotierten Gebietes 3 freigelegt ist (siehe Figur 4). N-dotiertes Silizium, das das Ausgangsmaterial des Siliziumsubstrats 1 ist, wird vollständig entfernt. Es verbleibt nur das p⁺⁻dotierte Gebiet 3. Auf der freiliegenden Oberfläche des p⁺⁻dotierten Gebietes 3 wird ein zweiter Kontakt 7 aus zum Beispiel 1 um dickem Gold aufgebracht. Senkrecht zur ersten Hauptfläche 11 weist der aus erstem Kontakt 6, leitfähiger Schicht 5, dielektrischer Schicht 4, p⁺⁻dotiertem Gebiet 3 und zweitem Kontakt 7 gebildete Siliziumkondensator eine Abmessung von 180 um auf. Die Fläche des Siliziumkondensators beträgt zum Beispiel 0,9 x 0,9 mm². Er kann daher in üblicher Weise verwendete Gehäuse, zum Beispiel SMD-Gehäuse eingebaut werden.

Auf dem Substrat 1 können mehrere Siliziumkondensatoren hergestellt werden, die vor dem Einbau ins Gehäuse vereinzelt werden.

## Patentansprüche

1. Verfahren zur Herstellung mindestens eines Siliziumkondensators,
- bei dem in einer ersten Hauptfläche (11) eines n-dotierten Siliziumsubstrats (1) durch elektrochemisches Ätzen eine Vielzahl von Lochöffnungen (2) erzeugt werden,
- bei dem entlang der Oberfläche der Lochöffnungen (2) ein p⁺⁻dotiertes Gebiet (3) erzeugt wird,
- bei dem auf die Oberfläche der Lochöffnungen (2) eine dielektrische Schicht (4) aufgebracht wird,
- bei dem auf die dielektrische Schicht (4) eine elektrisch leitfähige Schicht (5) aufgebracht wird,
- bei dem das Siliziumsubstrat (1) von einer zweiten, der ersten Hauptfläche (11) gegenüberliegenden Hauptfläche (12) her durch eine Ätzung gedünnt wird, die Silizium selektiv zu p⁺⁻dotiertem Silizium angreift und die daher auf der Oberfläche des p⁺⁻dotierten Gebietes stoppt,
- bei dem die leitfähige Schicht (5) und das p⁺⁻dotierte Gebiet (3) jeweils mit einem Kontakt (6, 7) versehen werden.

2. Verfahren nach Anspruch 1, bei dem das p⁺⁻dotierte Gebiet (3) durch Gasphasendiffusion mit Diboran erfolgt, wobei eine Dotierstoffkonzentration im p⁺⁻dotierten Gebiet von größer oder gleich 10¹⁹ cm-³ eingestellt wird.

3. Verfahren nach Anspruch 1 oder 2, bei dem die Ätzung zur Dünnung des Siliziumsubstrats (1) mit KOH, NaOH oder mit Ethylendiamin durchgeführt wird.

4. Verfahren nach einem der Ansprüche 1 bis 3,
- bei dem die Ätzung zur Dünnung des Siliziumsubstrats (1) solange durchgeführt wird, bis das p⁺⁻dotierte Gebiet (3) von der zweiten Hauptfläche (12) her freigelegt ist,
- bei dem das p⁺⁻dotierte Gebiet (3) von der zweiten Hauptfläche (12) her mit dem Kontakt (7) versehen wird.

5. Verfahren nach Anspruch 4,
bei dem das p⁺⁻dotierte Gebiet (3) mit einer Dotierungstiefe im Bereich zwischen 0,5 um und 1,5 um gebildet wird.

6. Verfahren nach einem der Ansprüche 1 bis 5,
- bei dem die elektrochemische Ätzung zur Bildung der Lochöffnungen (2) in einem fluoridhaltigen, sauren Elektrolyten, mit dem die erste Hauptfläche (11) in Kontakt steht und zwischen den und das Siliziumsubstrat (1) eine Spannung so angelegt wird, daß das Siliziumsubstrat als Anode verschaltet wird, gebildet werden,
- bei dem die zweite Hauptfläche (12) des Siliziumsubstrats (1) während der elektrochemischen Ätzung beleuchtet wird.

7. Verfahren nach Anspruch 6,
bei dem die Lochöffnungen (2) mit Durchmessern im Bereich 0,5 um bis 10 um und mit Tiefen im Bereich 50 um bis 300 um erzeugt werden, wobei die Lochöffnungen ein Aspektverhältnis im Bereich von 30 um und 300 um aufweisen.

8. Verfahren nach einem der Ansprüche 1 bis 7, bei dem die dielektrische Schicht (4) durch kombinierte Erzeugung von Si0₂ und Si3N4 als Mehrfachschicht mit einer Schichtenfolge SiO₂/Si₃N₄/SiO₂ gebildet wird.

9. Verfahren nach einem der Ansprüche 1 bis 8, bei dem die leitfähige Schicht (5) durch Gasphasenabscheidung von dotiertem Polysilizium gebildet wird.
